(19) Europäisches Patentamt

European Patent Office

Office européen des brevets

(11) **EP 1 069 689 A2**

(12) **EUROPEAN PATENT APPLICATION**

(43) Date of publication:
**17.01.2001 Bulletin 2001/03**

(51) Int. Cl.⁷: **H03M 1/00**

(21) Application number: **00305267.7**

(22) Date of filing: **21.06.2000**

(84) Designated Contracting States:
**AT BE CH CY DE DK ES FI FR GB GR IE IT LI LU
MC NL PT SE**
Designated Extension States:
**AL LT LV MK RO SI**

(30) Priority: **12.07.1999 US 352165**

(71) Applicant:
**Nortel Networks Limited
Montreal, Quebec H2Y 3Y4 (CA)**

(72) Inventor: **Hudson, John
Stansted, Essex CM24 8LR (GB)**

(74) Representative:
**Ryan, John Peter William
Nortel Networks
Intellectual Property Law Group
London Road
Harlow, Essex CM17 9NA (GB)**

(54) **Viterbi demodulator optimised for non-gaussian noise**

(57)    A method and apparatus for decoding a convolutionally coded digital signal by use of a Viterbi algorithm having an associated Viterbi metric, a non-quadratic Viterbi metric being selected to perform optimally in the presence of non-Gaussian noise.

*Fig. 6*

EP 1 069 689 A2

Printed by Xerox (UK) Business Services
2.16.7 (HRS)/3.6

**Description**

**FIELD OF THE INVENTION**

The present invention relates to a method and apparatus for demodulating telecommunications signals subject to non-Gaussian noise and interference, and a system incorporating the same.

**BACKGROUND TO THE INVENTION**

Typically, radio path transmission will suffer from both random noise, interference and fading, and the second generation (2G) GSM (Global System for Mobile communications) has adopted a convolution coding scheme to protect against data error from these effects. Convolution coding combined with interleaving has been shown to be an efficient form of forward error correction block coding. It has been shown to be superior to binary block code for random errors and to give similar performance to a Reed Solomon code for burst errors, provided suitable block interleaving is employed. Convolution coding will also be employed in 3G (third generation) mobile telephone systems for speech channels and in the form of turbo coding for data channels.

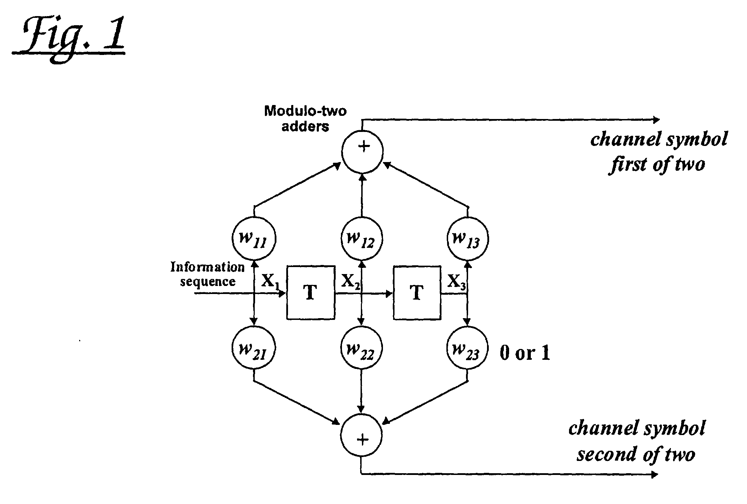

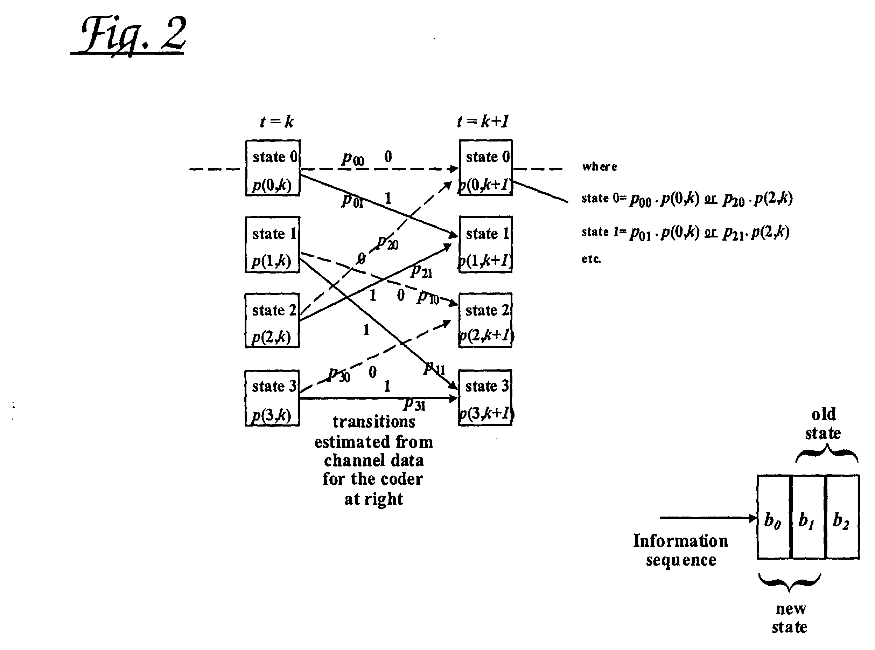

Figure 1 shows a typical 4-state half-rate convolutional encoder as might be present at a transmitter, in which each information bit is represented by two channel bits or symbols, whilst Figure 2 shows one stage in a corresponding Viterbi receiver decoder structure.

As Figure 1 shows, encoding an information sequence into channel symbols for transmission is a relatively simple operation. The information sequence is fed sequentially into shift registers ($x_1...x_3$), weighted by a predetermined weighting function ($w_{11}...w_{23}$), and an exclusive-OR operation is performed on the information bits to derive the channel symbols in a linear algebraic Galois field. The sequence for channel signals may then be modulated onto a carrier and transmitted in the resulting radio channel.

Decoding the received signal however is a much more complex process and typically a Viterbi algorithm provides the most efficient statistically optimum solution. In such an algorithm, the coder outputs for all possible combinations of data in the transmitter shift registers are established and the received group of channel symbols (a group of two as shown) is compared to them. A cost function is then computed for each comparison which is designed to reflect the type of noise expected. As the information sequence proceeds through a block of data the cumulative cost figure is accumulated and at the end of the block (typically 160 bit pairs for half-rate 8 kbit/s speech channel in 3G) the sequence with the minimum cost function is chosen as the correct solution.

The probability of the transitions is determined by comparing numerically the channel symbols associated with each information bit with their ideal counterparts. In the receiver the states at the start and end of each transition determine the associated (putative) information sequence and channel symbols which would be generated at the transmitter. In general the greater the difference between the observed channel symbols and the expected channel symbols, the smaller is the probability that that is a good transition to select. At the right side of each transition two or more transitions merge into each state. The dynamic programming principle states that it is sufficient to select the path which leads to the greatest total probability after the transition as the correct path decision, and to discard the other path(s). As indicated in Figure 2, this final probability value is the better of the products of each left side state probability and the associated transition probability.

Figure 2 shows a state transition stage in a conventional Viterbi demodulator. The left side states number $2^{N-1}$, when there are N stages in the coder register of Figure 1, and represent the possible permutations of the previous $N$-1 bits in the information sequence between times $k$-$N$+1 and $k$ and their associated probabilities. The right side states represent the sequence between times $k$-$N$+2 and $k$+1. Joining the left and right side states are a number of transitions whose probabilities are estimated by comparing the received channel symbols with the ideal ones which would result if there were no noise. The transitions are coded onto the physical channel by a convolutional coder at the transmitter and each information bit can be represented by 2,3 or more physical channel symbols by varying the number of coder rows shown in Figure 1.

Conventionally a Gaussian channel noise model is used and the probability of a transition is determined from the Gaussian probability distribution and the observed errors relative to a supposed data sequence. If the channel symbols expected are say $s_1$, $s_2$ etc. and the observed symbols are $x_1$, $x_2$ then the probability of the transition is proportional to the appropriate displacement in the 2-dimensional Gaussian PDF (probability density function)

$$p(x_1, x_2) = \frac{1}{2\pi\sigma^2} \exp\left(-\frac{(x_1\text{-}s_1)^2}{2\sigma^2}\right) \exp\left(-\frac{(x_2\text{-}s_2)^2}{2\sigma^2}\right) \tag{1}$$

It is conventional to work in log probabilities and eqn (1) becomes

$$\log\{p(x_1,x_2)\} = \log\left\{\frac{1}{2\pi\sigma^2}\right\} - \frac{(x_1 - s_1)^2}{2\sigma^2} - \frac{(x_2 - s_2)^2}{2\sigma^2} \tag{2}$$

and when this is done the log metrics accumulate additively rather than multiplicatively and the leading constant term and the noise standard deviation $\sigma$ can be omitted from equation (2) since these do not affect the relative probabilities of the various sequences.

In congested traffic conditions the noise is dominated by interference from other users. Several authors (Jacek Ilow and Dimitrios Hatzinakos: "Analytic alpha-stable Noise Modeling in a Poisson field of Interferers or Scatterers", IEEE Trans. Sig. Proc. 46(6), June 1998 pp. 1601-1611; D. Middleton: "Statistical Physical models of Electromagnetic Interference", IEEE Trans. Electromagnetic Compat. EMC-19(3), 1977, pp 106-127; and D. Middleton: "Procedures for Determining the Parameters of the First Order Canonical Models of Class A and Class B Electromagnetic Interference", IEEE Trans. Electromagnetic Compat. EMC-21(3), 1979 pp 190-208) have predicted that heavy tailed interference distributions can arise in cellular systems given an appropriate environment and waveform format. When deinterleaving is performed on the received data prior to the Viterbi decoder stage these non-Gaussian fading distributions are transformed into random time sequences and produce non-Gaussian interference in the Viterbi decoders, which significantly changes its operating characteristics and generally degrades performance.

B. Mulgrew *et al* (Paper entitled "A MAP Equaliser for Impulse Noise Environments" presented at the Conference on "Mathematics in Communications", hosted by the Institute of Mathematics and its Applications at the University of Loughborough in December 1998) describe how the problem of impulse noise might be compensated using neural networks. L. Favalli *et al* ("Blind MLSE equaliser with fuzzy metric calculation for mobile radio environments", Electronics Letters, 1997, pp 1841-1842) describe how fuzzy logic has been applied in the computation of metrics for Viterbi decoders, although provide insufficient information to determine how the claimed results were achieved.

In cellular wireless telecommunication systems, own-cell interference is not normally a problem in CDMA (Code Division Multiple Access) since users are up-link power controlled to the common base station. However, the surrounding cells contain interferences which are power controlled with respect to only their own bases, and this will result in differential pass fading and log-normal shadowing between their own bases paths and those of the central base. Such noise might also include atmospheric noise or ambient acoustic noise that might come from sources such as relay contacts, eletro-magnetic devices, electronic apparatus, or transportation systems, switching transients and accidental hits in telephone lines.

There exists a need for a Viterbi decoder that is less susceptible to degradation in performance with non-Gaussian noise, including interference.

## OBJECT OF THE INVENTION

The invention seeks to provide an improved method and apparatus for demodulating telecommunications signals, particularly those subject to non-Gaussian noise.

## SUMMARY OF THE INVENTION

In one aspect, the present invention provides a method of decoding a convolutionally coded digital signal by use of a Viterbi algorithm having an associated Viterbi metric, wherein said Viterbi metric is a non-quadratic metric selected to perform optimally in the presence of non-Gaussian noise. Consequently, the Viterbi algorithm which is typically used in decoding such convolution code, may be modified to be suitable for different noise conditions.

Preferably, said Viterbi metric is of the form $\exp(-(\frac{\varepsilon}{\sigma})^\rho)$ , where $\varepsilon$ is the

Euclidean distance of the observed received symbol from the ideal symbol $\sigma$, and $\rho$ has a value within the range $0 \leq \rho < 2$.

Alternatively, the Viterbi metric is derived from observed interference statistics determined from said digital signal. The metric may hence be optimised from measurement of the digital signal and its associated channel noise.

Preferably, the noise probability distribution associated with the digital signal is derived from said interference statistics.

These observed interference statistics may be derived when the telecommunication system is being set up by sending test digital signals, or by "on-line" analysis of digital signals received whilst the system is in normal operation. Obviously, such on-line analysis could be performed periodically or continuously.

Preferably, a Turbo code implementation is used. This would be particularly suitable for data communication.

In a further aspect, the present invention provides software on a machine-readable medium embodying the method as described above.

In another aspect, the present invention provides a Viterbi decoder comprising means to receive an input signal comprising a series of symbols, and means to decode successive symbols in response to a value of a Viterbi metric applied to preceding symbols, wherein said Viterbi metric is non-quadratic.

Preferably, said decoder has means for choosing said non-quadratic metric in response to the anticipated actual probability distribution function of noise within said input signal.

Preferably, the decoder is arranged to receive a plurality of input signals, each signal consisting of a sequence of symbols, said decoder further comprising means for deriving the transition probabilities of the Viterbi metric based on the product of the probabilities of the individual received channel symbols. Such signals could be a number of signals received simultaneously (or relatively close together), a sequence of successive signals, or a combination thereof. For instance, the plurality of signals could be a sequence of signals received by a single antenna. Alternatively, the signals could be from different elements of a receiving antenna array, and relate to either the same transmitted signal, or to different transmitted signals.

Preferably, the decoder is arranged to receive a plurality of signals in which the additive noises associated with the respective signals are approximated to be mutually independent, and the decoder further comprises means for computing said Viterbi metric in response to said input signals and a product of the respective probability density functions associated with said signals.

For instance, the decoder could hence be arranged to decode a plurality of time-correlated signals.

Preferably, the decoder is arranged to receive a plurality of signals in which the additive noises associated with respective signals are approximated to be inter-dependent, and the decoder further comprises means for computing said Viterbi metric in response to said input signals and a joint probability density function derived from the respective probability density functions associated with said signals. For instance, the decoder could hence be arranged to decode a plurality of spatially-correlated signals.

Preferably, the decoder is arranged to compute said Viterbi metric in response to a joint probability density function characteristic of the noises associated with a plurality of consecutive samples of said signal.

Preferably, the decoder is arranged to receive a plurality of signals in which the additive noises associated with respective signals are approximated to be inter-dependent, and the decoder is arranged to compute said Viterbi metric in response to said input signals and a joint probability density function derived from the respective probability density functions associated with said signals and in response to a joint probability density function characteristic of the noises associated with a plurality of consecutive samples of at least one of said plurality of signals. For instance, the decoder could hence be arranged to decode a plurality of time and spatially-correlated signals.

Preferably, the decoder is in or for a receiver comprising a plurality of receiving antennas, and is arranged to derive said transition probabilities in response to at least one value of a non-Gaussian metric applied to one or more signals received on said antennas.

Preferably, the noise is correlated between the input signals, and said decoder comprises means for computing the transition probabilities of the Viterbi metric based on the joint probability distribution of the received channel symbols present at all elements.

Preferably, the decoder further comprises a multi-stage Viterbi demodulator arranged to concatenate two or more samples of the channel data so as to generate an enhanced number of states, said demodulator being arranged to utilise a non-linear Viterbi metric computed from the joint probability distribution of the noise over said two or more consecutive samples of said channel data.

Preferably, the decoder is arranged to estimate channel impulse response from measurement of the channel symbols then to utilise a non-gaussian Viterbi metric derived from the probability distribution of noise for estimation of the channel symbol sequence when said signal is corrupted by additive white non-Gaussian noise.

In further aspect, the present invention provides a receiver including a decoder as described above.

Preferably, said receiver is a mobile wireless receiver arranged to receive signals transmitted from a base station transmitter implementing downlink diversity options such as phase sweeping, transmit space diversity, amplitude sweeping or time space coding.

In another aspect, the present invention provides a telecommunications system comprising a decoder or a receiver as described above.

The invention is also directed to a method by which the described apparatus operates and including steps for carrying out every function of the apparatus, as well as to an apparatus including means for carrying out every function of the method.

The invention also provides for a system for the purposes of digital signal processing which comprises one or more instances of apparatus embodying the present invention, together with other additional apparatus.

The preferred features may be combined as appropriate, as would be apparent to a skilled person, and may be combined with any of the aspects of the invention.

## BRIEF DESCRIPTION OF THE DRAWINGS

In order to show how the invention may be carried into effect, embodiments of the invention are now described below by way of example only and with reference to the accompanying figures in which:

Figure 1 shows an example of a simple binary convolutional encoder;

Figure 2 shows an example of a receiver structure for decoding convolutional channel code;

Figure 3 shows an example of a multichannel Viterbi decoder (2 channels shown);

Figure 4 shows an example of demodulation of dependent noise;

Figure 5 shows a graph of performance of various Viterbi metrics, for Gaussian interference;

Figure 6 shows an example of a decoding path in a GSM receiver;

Figure 7 shows the performance of various Viterbi metrics for the example of Figure 6 subject to Rayleigh interference;

Figure 8 shows an example of a decoding path in a UTRA 3$^{rd}$ gen. receiver;

Figure 9 shows a graph of performance of various Viterbi metrics for the example of Figure 8 subject to Log-normal interference.

## DETAILED DESCRIPTION OF PREFERRED EMBODIMENTS

The invention relates to the operation of a non-linear Viterbi decoder in situations where the noise is non-Gaussian.
When the probability distribution of the noise is an arbitrary general function $p_G(.)$ then eqn (1) is replaced by

$$p_G(x_1, x_2) = p_G(x_1 - s_1) \cdot p_G(x_2 - s_2) \tag{3}$$

It is possible to continue to operate in log space for numerical stability reasons

$$\log\{p_G(x_1, x_2)\} = \log\{p_G(x_1 - s_1)\} + \log\{p_G(x_2 - s_2))\} \tag{4}$$

In most cases of non-Gaussian signals the PDF's involved will not have a straightforward mathematical representation and Equation (4) can be replaced by a look up table. In the case of non-linear metrics the PDF is usually explicitly dependent on the actual noise variance in a way that prevents mathematical cancellation of the standard deviation as was done in the equation above. In other words a non-linear demodulator will require the noise level to be known.
When the receiver has multiple antennas, then the system above generalises easily to include this case. If the noises are independent from element to element and the transition probabilities measured at antennas $k = \{1...N\}$ are $\log_k\{p(x_1, x_2)\}$ then the total transition probability is

$$\log\{p(x_1, x_2)\} = \log \prod_{k=1}^{N} p_k(x_1 - s_1) \cdot p_k(x_2 - s_2) \tag{5}$$

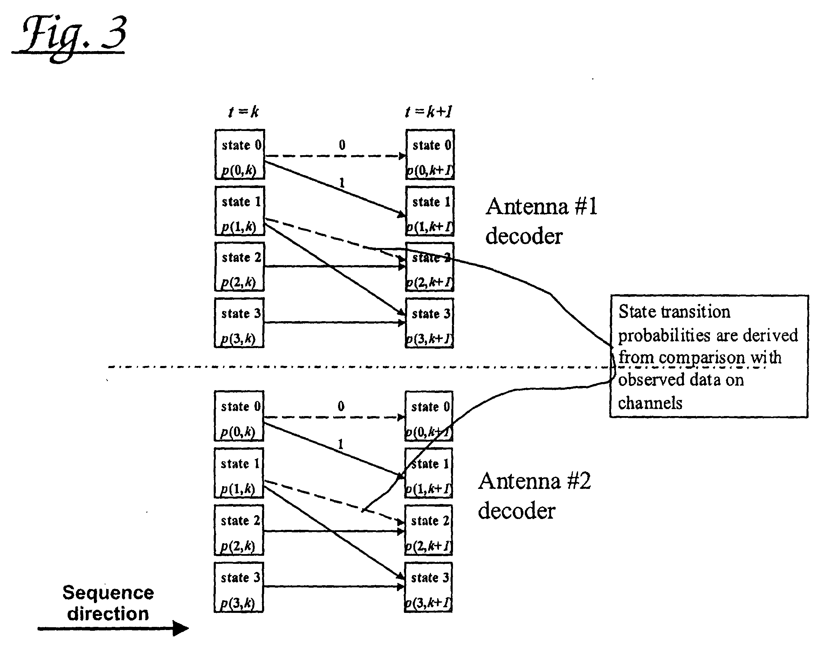

This system is shown in Figure 3.
In the case where the noise has a known joint probability distribution $p(n_1...n_N)$ between the elements of the antenna, though still remains independent between the various symbols of the convolutional code then the transition probability is

$$\log\{p(x_1,x_2)\} = \sum_{k=1}^{N} \log{}_k\{p(x_1 - s_1)\} + \log\{p(x_2 - s_2)\}\} \tag{6}$$

When the non-Gaussian noise is not white in the time domain then data demodulation decisions for consecutive transitions are not independent. One way to handle this situation is as follows. If the interference is considered to be a first order discrete Markov sequence then the noise during a transition is dependent on the immediately preceding noise value, but not on any earlier ones. This case covers first order recursive filtering. If the noise is a second order Markov sequence then the noise at time $k$ is dependent on noise samples at $k$-1 and $k$-2 but not on earlier ones. Second order sequences can model noise which has been filtered through a second order Butterworth or Chebychev digital filter for example.

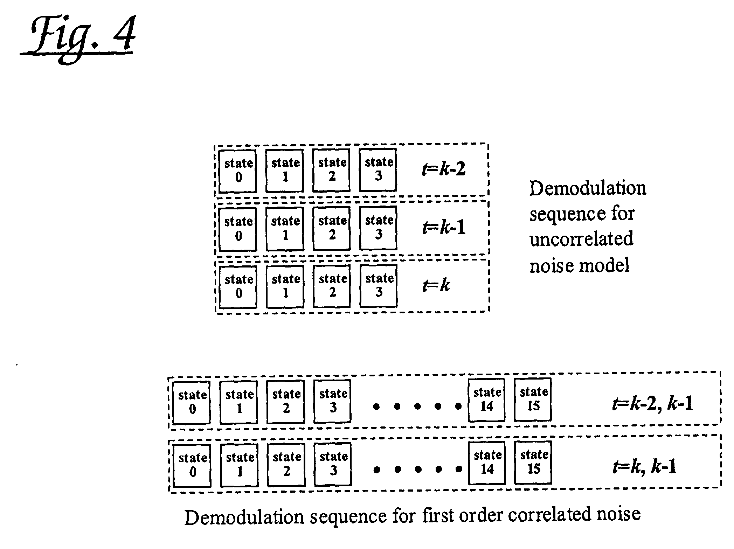

To model the state transitions two or more consecutive stages are concatenated into one. If the demodulator is a 4 state one then there are 16 possible states for two stages, as shown in Figure 4. There are 64 states for a second order process. At each stage the error metric probability distribution has a smaller dimensionality than the number of states since some fraction of the state transitions are discarded between $k$-1 and $k$ so it is only necessary to include the successful transition probabilities in the computation.

The main feature of the non-linear metrics is that they have heavier tails than the Gaussian distribution and this affects the likelihood ratios of deciding alternate unit amplitude data sequences as follows:

$$\text{Likelihood ratio} = \frac{P(x|s=+1)}{P(x|s=-1)} = \frac{f(x-1)}{f(x+1)} \tag{7}$$

For a Gaussian distribution the likelihood ratio (LR) actually diverges significantly for large excursions of the sampled value

$$LR = \frac{\exp\left(-\dfrac{(x-1)^2}{2\sigma^2}\right)}{\exp\left(-\dfrac{(x+1)^2}{2\sigma^2}\right)} = \exp\left(\frac{4x}{2\sigma^2}\right) \tag{8}$$

In the case of an exponential metric we get

$$LR = \frac{\exp(-(x-1))}{\exp(-(x+1))} = \exp(2) \tag{9}$$

which remains constant. For heavy tailed metrics which decay more slowly, of the form $\exp(-(x-s)^p)$ with p<1 the likelihood ratio will converge on unity for large noise excursions and noise impulses bias the data sequence very little. One form of metric is the algebraic one

$$\text{Transition probability} \propto \frac{K}{\sigma^2 + \varepsilon^p} \tag{10}$$

where $0 < \rho < \infty$. However in the simulations reported below an error metric of the form

$$\text{Transition probability} \propto \exp\left(-\left(\frac{\varepsilon}{\sigma}\right)^\rho\right) \tag{11}$$

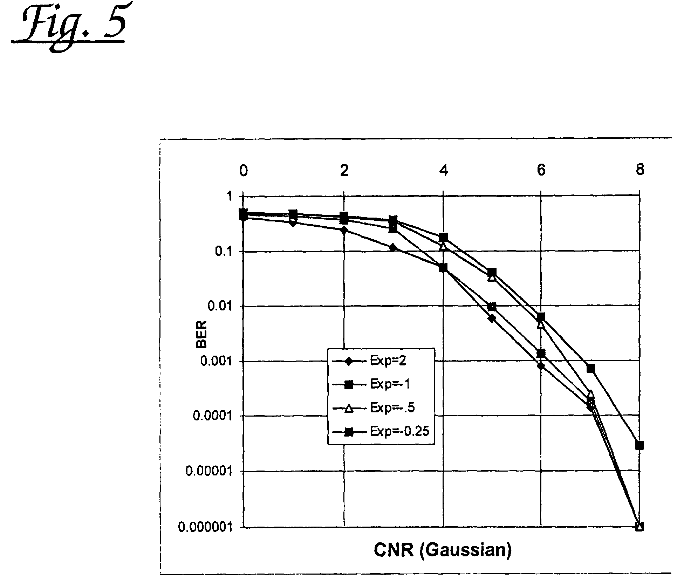

has been used where $\varepsilon$ is the Euclidean distance of the observed received symbol from the ideal symbol and $\rho$ can vary between 2 (standard Gaussian metric) down to 0.25 or less (heavy-tailed metrics). For later reference, Figure 5 shows the performance of a receiver operating in Gaussian noise (as indicated by the Channel to Noise Ratio, CNR) when various values of ρ (the power or exp) are used. It is seen that the performance is degraded for values of ρ less than the ideal of 2. This situation reverses for non-Gaussian interference. This metrics are used only for examples and are not meant to imply that other metrics may not be more suitable in different situations. In this section some specific examples of non-receivers based on certain known probability distributions are described.

1) Second Generation GSM base and mobile station receiver

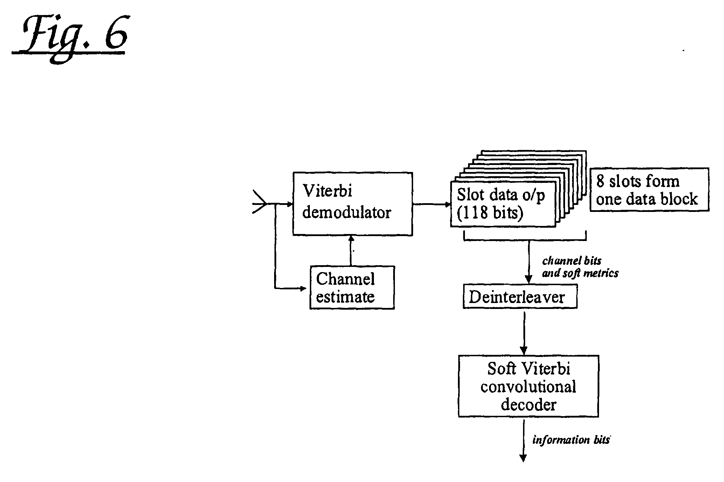

The demodulation channel for this application is shown in Figure 6. The RF (radio frequency) data is demodulated in a Viterbi demodulator a slot at a time (one slot ~ 0.5 ms) and the data in a block of 8 consecutive slots (at the rate of one slot per frame of 4 ms) is reassembled by the de-interleaver. In current designs each slot output is accompanied by a soft metric which indicates the quality of the data in a whole slot. When the block is deinterleaved this means the eight soft metrics are spread around the block in a random fashion. The data at this point is still half rate coded. The soft Viterbi convolutional decoder decodes the half rate code to produce the actual speech bits. It is proposed that the non-linear Viterbi algorithm would be used in this second decoding operation.

The interference in GSM systems is mostly inter-cell interference and can be expected to have a Rayleigh fading envelope. Thus the soft metrics in the demodulator will be associated with this probability distribution rather than additive white Gaussian noise (AWGN).

Referring to the same figure it will be realised that it is also possible to use non-linear metrics in the Viterbi demodulator section.

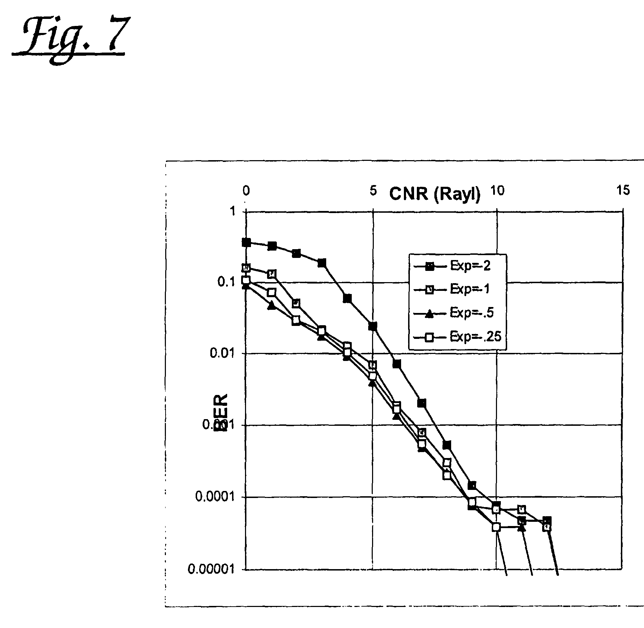

Figure 7 shows the performance of various non-linear metrics for an interference which has a Rayleigh modulated Gaussian distribution. The TX uses 1024-bit data blocks followed by a 1/3 rate convolutional coder.

The Exp=2 case corresponds to the standard Gaussian-noise metric used for Viterbi decoders and this has worse performance than all of the modified metrics. In a GSM demodulator the limiting BER (Bit Error Rate) is of the order of say 0.1% and a processing gain of up to 2 dB is available at this BER. Note that this Rayleigh fading improvement is achieved at a cost of >2 dB worse performance for static Gaussian noise from Figure 5. This is not a problem in practice since both types of metrics can be run in parallel and the better one used. Alternatively, a single metric (for example one where the exponent ρ equals two) could be used which has reasonable operating characteristics for both Gaussian and non-Gaussian noise conditions (as indicated in Figures 5, 7 and 9 for ρ equals 1).

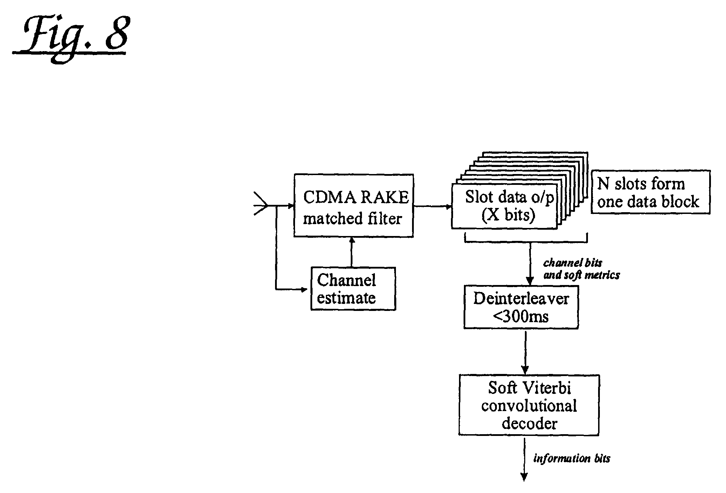

2) In third generation cellular CDMA (Code Division Multiple Access) applications the particular problem which is likely to occur on many occasions is both Rayleigh or log-normally distributed interference. The signal path for the UTRA (UMTS (Universal Mobile Telecommunication System) Terrestial Radio Access) 3G system looks like Figure 8 and is much more flexible than the GSM system. Here, for data transfers, the frame length is nominally 10ms divided into 16 slot of 625 µS. However data can be de-interleaved over time spans of up to 300 ms under the ITU (International Telecommunications Union) proposals dated 30 June 1998). Interference can arise from speech users or other data users and in microcells much of the interference can come from the adjacent cells which are not locally power controlled. If the interference is fading, or is intrinsically bursty such that a variety of interference sources are cycled through in the 300 ms de-interleaving span then non-Gaussian interference is again expected to occur. In standard FDD (frequency division duplex) mode the spreading ratios of interference and desired signal can vary over a range of about 4096:1 by varying the length of the CDMA "symbols". Bursty log-normally distributed interference can be present from nearby cells, likely to be significant in metropolitan microcells. These interference source are power controlled with respect to their own bases but the shadowing to other cells will not be completely correlated and the interference caused by these extra-cell users will have a log-normal distribution. Although the interference form each source is steady, as sources come and go the total interference level will vary randomly in a log-normal fashion. After matched filtering to demodulate the symbols, the data is deinterleaved on a bit by bit basis and the log-normal interference variation will be transformed into uncorrelated noise with a non-Gaussian probability distribution.

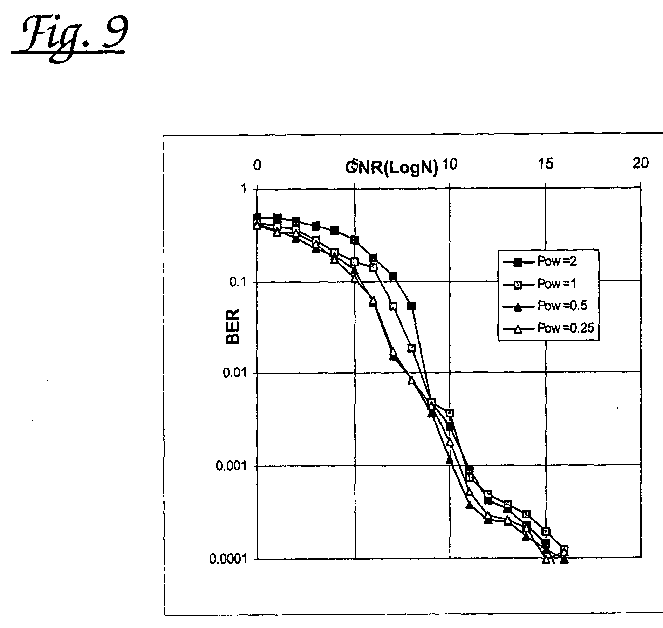

Figure 9 shows the comparative BER curves for a situation where the noise is a Gaussian signal modulated by Log-normal fading with a standard deviation σ of 10 dB. The TX (transmitter) again uses 1024-bit data blocks followed by a 1/3 rate convolutional coder.

The gain available is somewhat less than for Rayleigh fading. However note that the log-normal fading model is only an approximation and a variety of distributions could arise in practice due to fading or bursty interference and more gain will be present for at least a proportion of these cases.

    i) Second generation mobile radio offering enhanced mobile and base station receiver performance in fast fading when interleaving takes place over 40ms frames (GSM) or similar procedures used in CDMA or DAMPS (Digital Advanced Mobile Phone Service).

    ii) Third generation cellular and mobile radio as above. Also offering enhanced base station and mobile receiver performance in the presence of log-normal fading and bursty interference when interleaving takes place over extended time intervals of 300ms frames.

Any range or device value given herein may be extended or altered without losing the effect sought, as will be apparent to the skilled person for an understanding of the teachings herein. For instance, whilst the preferred embodiments of the present invention have been described in conjunction with wireless communications systems, it will of course be appreciated that the invention may equally be applied to wireless systems, e.g. optical fibre, powerline (transmission of digital signals over power supplying lines) or digital subscriber line transmission signals.

**Claims**

1. A method of decoding a convolutionally coded digital signal by use of a Viterbi algorithm having an associated Viterbi metric, wherein said Viterbi metric is a non-quadratic metric selected to perform optimally in the presence of non-Gaussian noise.

2. A method of decoding a signal as claimed in claim 1, wherein said Viterbi metric is of the form $\exp(-(\frac{\varepsilon}{\sigma})^\rho)$, where $\varepsilon$ is the Euclidean distance of the observed received symbol from the ideal symbol $\sigma$, and $\rho$ has a value within the range $0 \leq \rho \leq 2$.

3. A method of decoding a signal as claimed in claim 1 or claim 2, wherein said Viterbi metric is derived from observed interference statistics determined from said digital signal.

4. A method of decoding a signal as claimed in claim 3, wherein the noise probability distribution associated with the digital signal is derived from said interference statistics.

5. A method of decoding a signal as claimed in any of the above claims, wherein a Turbo code implementation is used.

6. Software on a machine-readable medium embodying the method of any of the above claims.

7. A Viterbi decoder comprising means to receive an input signal comprising a series of symbols, and means to decode successive symbols in response to a value of a Viterbi metric applied to preceding symbols, wherein said Viterbi metric is non- quadratic.

8. A decoder as claimed in claim 7, further comprising means for choosing said non-quadratic metric in response to the anticipated actual probability distribution function of noise within said input signal.

9. A decoder as claimed in claim 7 or claim 8, arranged to receive a plurality of input signals, each signal consisting of a sequence of symbols, said decoder further comprising means for deriving the transition probabilities of the Viterbi metric based on the product of the probabilities of the individual received channel symbols.

10. A decoder as claimed in claim 7, 8 or 9, arranged to receive a plurality of signals in which the additive noises associated with the respective signals are approximated to be mutually independent, and the decoder further comprises means for computing said Viterbi metric in response to said input signals and a product of the respective probability density functions associated with said signals.

11. A decoder as claimed in any of claims 7 to 10 arranged to receive a plurality of signals in which the additive noises associated with respective signals are approximated to be inter-dependent, and the decoder further comprises means for computing said Viterbi metric in response to said input signals and a joint probability density function derived from the respective probability density functions associated with said signals.

12. A decoder as claimed in any of claims 7 to 11 arranged to compute said Viterbi metric in response to a joint probability density function characteristic of the noises associated with a plurality of consecutive samples of said signal.

13. A decoder as claimed in any of claims 7 to 12 arranged to receive a plurality of signals in which the additive noises associated with respective signals are approximated to be inter-dependent, and the decoder is arranged to compute said Viterbi metric in response to said input signals and a joint probability density function derived from the respective probability density functions associated with said signals and in response to a joint probability density function characteristic of the noises associated with a plurality of consecutive samples of at least one of said plurality of signals.

**14.** A decoder as claimed in any of claims 7 to 13, in or for a receiver comprising a plurality of receiving antennas, and is arranged to derive said transition probabilities in response to at least one value of a non-Gaussian metric applied to one or more signals received on said antennas.

**15.** A decoder as claimed in any of claims 7 to 14, wherein noise is correlated between the input signals, and said decoder comprises means for computing the transition probabilities of the Viterbi metric based on the joint probability distribution of the received channel symbols present at all elements.

**16.** A decoder as claimed in any of claims 7 to 15, comprising a multi-stage Viterbi demodulator arranged to concatenate two or more samples of the channel data so as to generate an enhanced number of states, said demodulator being arranged to utilise a non-linear Viterbi metric computed from the joint probability distribution of the noise over said two or more consecutive samples of said channel data.

**17.** A decoder as claimed in any of claims 7 to 16, arranged to estimate channel impulse response from measurement of the channel symbols then to utilise a non-linear Viterbi metric derived from the probability distribution of noise for estimation of the channel symbol sequence when said signal is corrupted by additive white non-Gaussian noise.

**18.** A receiver including a decoder as claimed in any of claims 7 to 17.

**19.** A receiver as claimed in claim 18, wherein said receiver is a mobile wireless receiver arranged to receive signals transmitted from a base station transmitter implementing downlink diversity options such as phase sweeping, transmit space diversity, amplitude sweeping or time space coding.

**20.** A telecommunications system comprising a decoder as claimed in any of claims 7 to 17.

EP 1 069 689 A2

# *Fig. 1*

Modulo-two
adders

channel symbol
*first of two*

$w_{11}$ $w_{12}$ $w_{13}$

Information
sequence $X_1$ | T | $X_2$ | T | $X_3$

$w_{21}$ $w_{22}$ $w_{23}$ 0 or 1

channel symbol
*second of two*

Fig. 2

*Fig. 3*

Sequence direction

# *Fig. 4*

Demodulation sequence for uncorrelated noise model

Demodulation sequence for first order correlated noise

EP 1 069 689 A2

**Fig. 5**

BER vs CNR (Gaussian)

Legend: Exp=2, Exp=1, Exp=.5, Exp=-0.25

EP 1 069 689 A2

# *Fig. 6*

Viterbi demodulator

Channel estimate

Slot data o/p (118 bits)

8 slots form one data block

*channel bits and soft metrics*

Deinterleaver

Soft Viterbi convolutional decoder

*information bits*

Fig. 7

*Fig. 8*

N slots form
one data block

Slot data o/p
(X bits)

*channel bits*
*and soft metrics*

CDMA RAKE
matched filter

Channel
estimate

Deinterleaver
<300ms

Soft Viterbi
convolutional
decoder

*information bits*

17

Fig. 9